# EUROPEAN PATENT SPECIFICATION

(11) **EP 1 190 303 B1**
(45) Date of publication and mention of the grant of the patent: **17.12.2003**
(21) Application number: 00928970.3
(22) Date of filing: 12.05.2000
(51) Int. Cl.: G06F 9/38

(54) **METHOD AND APPARATUS FOR JUMP CONTROL IN A PIPELINED PROCESSOR**
VERFAHREN UND VORRICHTUNG ZUR VERZWEIGUNGSSTEUERUNG IN EINEM PIPELINEPROZESSOR
PROCEDE ET DISPOSITIF DE COMMANDE DE SAUT DANS UN PROCESSEUR PIPELINE

(30) Priority: 13.05.1999 US 134253 P; 14.10.1999 US 418663; 13.03.2000 US 523871
(43) Date of publication of application: 27.03.2002
(73) Proprietor: ARC International U.S. Holdings Inc., San Jose, CA 95119 (US)
(72) Inventor: HAKEWILL, James, Robert, Howar, Radlett, Hertfordshire WD7 8HZ (GB); SANDERS, Jon, Harrow, Wealdstone, Middlesex HA3 5HB (GB)
(74) Representative: Popp, Eugen, Dr.
(86) International application number: US0013030
(87) International publication number: WO00070444

(56) References cited:
- EP-A- 0 365 188
- WARREN H S: "INSTRUCTION SCHEDULING FOR THE IBM RISC SYSTEM/6000 PROCESSOR" IBM JOURNAL OF RESEARCH AND DEVELOPMENT,US,IBM CORPORATION, ARMONK, vol. 34, no. 1, 1990, pages 85-92, XP000128183 ISSN: 0018-8646
- "CONDITION REGISTER COHERENCY LOOK-AHEAD" RESEARCH DISCLOSURE,GB,INDUSTRIAL OPPORTUNITIES LTD. HAVANT, no. 348, 1 April 1993 (1993-04-01), page 243 XP000304185 ISSN: 0374-4353
- DITZEL D.R. AND MCLLELLAN H.R.: "Branch folding in the CRISP microprocessor: Reducing branch delay to zero" 14TH ANNUAL INTERNATIONAL SYMPOSIUM ON COMPUTER ARCHITECTURE, 2 - 5 June 1987, pages 2-8, XP000212073 Pittsburgh, PENN, US

## Description

### Background of the Invention

### 1. Field of the Invention

The present invention relates to the field of integrated circuit design, specifically to the use of a hardware description language (HDL) for implementing instructions in a pipelined central processing unit (CPU) or user-customizable microprocessor.

### 2. Description of Related Technology

RISC (or reduced instruction set computer) processors are well known in the computing arts. RISC processors generally have the fundamental characteristic of utilizing a substantially reduced instruction set as compared to non-RISC (commonly known as "CISC") processors. Typically, RISC processor machine instructions are not all microcoded, but rather may be executed immediately without decoding, thereby affording significant economies in terms of processing speed. This "streamlined" instruction handling capability furthermore allows greater simplicity in the design of the processor (as compared to non-RISC devices), thereby allowing smaller silicon and reduced cost of fabrication.

RISC processors are also typically characterized by (i) load/store memory architecture (i.e., only the load and store instructions have access to memory; other instructions operate via internal registers within the processor); (ii) unity of processor and compiler; and (iii) pipelining.

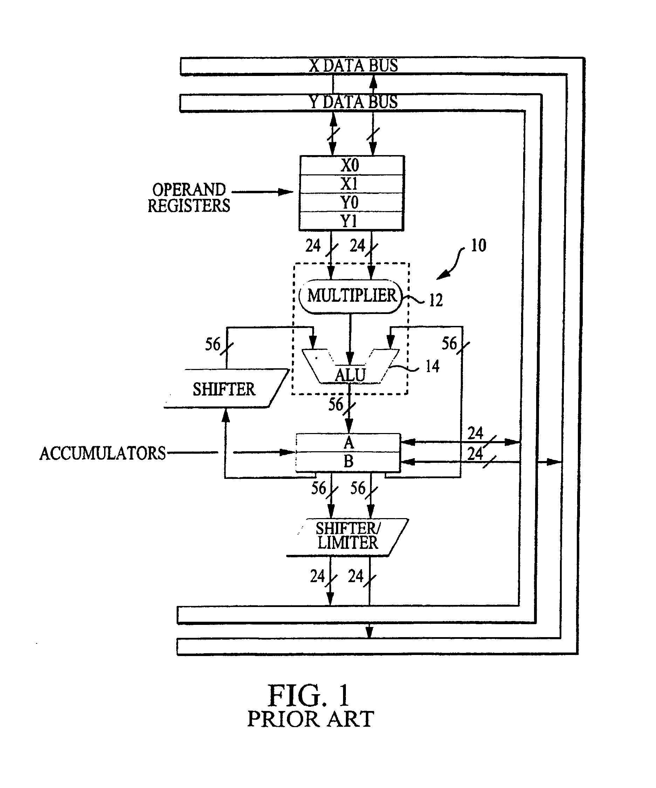

Pipelining is a technique for increasing the performance of processor by dividing the sequence of operations within the processor into segments which are effectively executed in parallel when possible. In the typical pipelined processor, the arithmetic units associated with processor arithmetic operations (such as ADD, MULTIPLY, DIVIDE, etc.) are usually "segmented", so that a specific portion of the operation is performed in a given segment of the unit during any clock cycle. Fig. 1 illustrates a typical processor architecture having such segmented arithmetic units. Hence, these units can operate on the results of a different calculation at any given clock cycle. As an example, in the first clock cycle two numbers A and B are fed to the multiplier unit 10 and partially processed by the first segment 12 of the unit. In the second clock cycle, the partial results from multiplying A and B are passed to the second segment 14 while the first segment 12 receives two new numbers (say C and D) to start processing. The net result is that after an initial startup period, one multiplication operation is performed by the arithmetic unit 10 every clock cycle.

The depth of the pipeline may vary from one architecture to another. In the present context, the term "depth" refers to the number of discrete stages present in the pipeline. In general, a pipeline with more stages executes programs faster but may be more difficult to program if the pipeline effects are visible to the programmer. Most pipelined processors are either three stage (instruction fetch, decode, and execute) or four stages (such as instruction fetch, decode, operand fetch, and execute, or alternatively instruction fetch, decode/operand fetch, execute, and writeback), although more or less stages may be used.

When developing the instruction set of a pipelined processor, several different types of "hazards" must be considered. For example, so called "structural" or "resource contention" hazards arise from overlapping instructions competing for the same resources (such as busses, registers, or other functional units) which are typically resolved using one or more pipeline stalls. So-called "data" pipeline hazards occur in the case of read/write conflicts which may change the order of memory or register accesses. "Control" hazards are generally produced by branches or similar changes in program flow.

Interlocks are generally necessary with pipelined architectures to address many of these hazards. For example, consider the case where a following instruction (n +1) in an earlier pipeline stage needs the result of the instruction n from a later stage. A simple solution to the aforementioned problem is to delay the operand calculation in the instruction decoding phase by one or more clock cycles. A result of such delay, however is that the execution time of a given instruction on the processor is in part determined by the instructions surrounding it within the pipeline. This complicates optimization of the code for the processor, since it is often difficult for the programmer to spot interlock situations within the code.

"Scoreboarding" may be used in the processor to implement interlocks; in this approach, a bit is attached to each processor register to act as an indicator of the register content; specifically, whether (i) the contents of the register have been updated and are therefore ready for use, or (ii) the contents are undergoing modification such as being written to by another process. This scoreboard is also used in some architectures to generate interlocks which prevent instructions which are dependent upon the contents of the scoreboarded register from executing until the scoreboard indicates that the register is ready. This type of approach is referred to as "hardware" interlocking, since the interlock is invoked purely through examination of the scoreboard via hardware within the processor. Such interlocks generate "stalls" which preclude the data dependent instruction from executing (thereby stalling the pipeline) until the register is ready.

Alternatively, NOPs (no-operation opcodes) may be inserted in the code so as to delay the appropriate pipeline stage when desired. This later approach has been referred to as "software" interlocking, and has the disadvantage of increasing the code size and complexity of programs that employ instructions that require interlocking. Heavily software interlocked designs also tend not to be fully optimized in terms of their code structures.

Another important consideration in processor design is program branching or "jumps". All processors support some type of branching instructions. Simply stated, branching refers to the condition where program flow is interrupted or altered. Other operations such as loop setup and subroutine call instructions also interrupt or alter program flow in a similar fashion. The term "jump delay slot" is often used to refer to the slot within a pipeline subsequent to a branching or jump instruction being decoded. The instruction after the branch (or load) is executed while awaiting completion of the branch/load instruction. Branching may be conditional (i.e., based on the truth or value of one or more parameters) or unconditional. It may also be absolute (e.g., based on an absolute memory address), or relative (e.g., based on relative addresses and independent of any particular memory address).

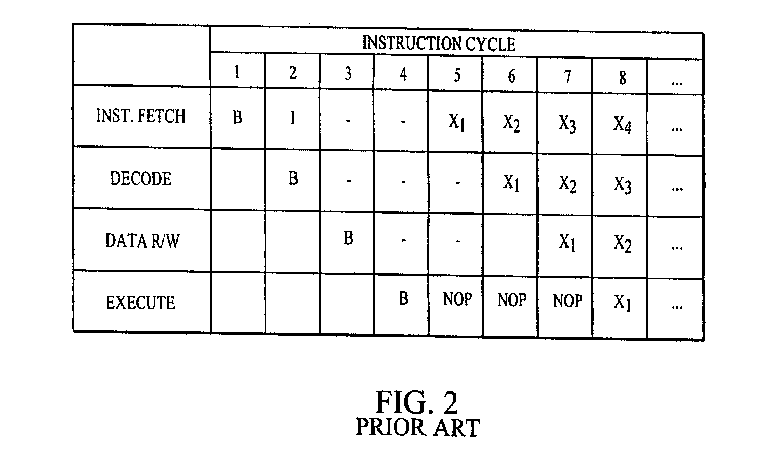

Branching can have a profound effect on pipelined systems. By the time a branch instruction is inserted and decoded by the processor's instruction decode stage (indicating that the processor must begin executing a different address), the next instruction word in the instruction sequence has been fetched and inserted into the pipeline. One solution to this problem is to purge the fetched instruction word and halt or stall further fetch operations until the branch instruction has been executed, as illustrated in Fig. 2. This approach, however, by necessity results in the execution of the branch instruction in several instruction cycles, this number typically being between one and the depth of the pipeline employed in the processor design. This result is deleterious to processor speed and efficiency, since other operations can not be conducted by the processor during this period.

Alternatively, a delayed branch approach may be employed. In this approach, the pipeline is not purged when a branch instruction reaches the decode stage, but rather subsequent instructions present in the earlier stages of the pipeline are executed normally before the branch is executed. Hence, the branch appears to be delayed by the number of instruction cycles necessary to execute all subsequent instructions in the pipeline at the time the branch instruction is decoded. This approach increases the efficiency of the pipeline as compared to multi-cycle branching described above, yet also complexity (and ease of understanding by the programmer) of the underlying code.

Various methods and apparatus for jump (branch) control within digital processors have been proposed in the prior art. See for example that described in Warren, H.S., "Instruction Scheduling for the IBM RISC System/6000 Processor", IBM Journal of Research and Development, IBM Corporation, vol. 34, no. 1, 1990, wherein separate branching and execution units are employed; the branching unit dispatches instructions to the execution unit, and at least partly decodes the instructions before dispatch to determine if the instructions will set or use condition registers (CR), and "locks" the CR field as appropriate. This architecture suffers from significant complexity, however, and does not afford the programmer the ability to schedule instructions into the pre-branch instruction slot which will not effect the subsequent branch. See also European Patent (Application) No. 0365188, Assigned to Appollo Computer Inc., entitled "Central processor condition code method and apparatus", and "Condition Register Coherency Look-ahead" research disclosure, Industrial Opportunities, Ltd., no. 348, April 1993, each of which disclose alternate yet less than optimal methods for implementing condition codes and controlling the operation of jump/branch instructions within processors.

Based on the foregoing, processor designers and programmers must carefully weigh the tradeoffs associated with utilizing hardware or software interlocks as opposed to a non-interlock architecture. Furthermore, the interaction of branching instructions (and delayed or multi-cycle branching) in the instruction set with the selected interlock scheme must be considered. What is needed is an improved approach to pipeline interlocking which optimizes processor pipeline performance and provides attributes of both hardware and software interlocks, while providing the programmer with additional flexibility of coding. Furthermore, as more pipeline stages (and even multiple multi-stage pipelines) are added to processor designs, the benefits of enhanced interlock performance and code optimization within the processor increase manifold. Additionally, the ability to readily synthesize such improved pipelined processor designs in an application-specific manner, and using available synthesis tools, is of significant utility to the designer and programmer.

### Summary of the Invention

The present invention satisfies the aforementioned needs by providing an improved method and apparatus as set out in claims 1 and 7 for executing instructions within a pipelined processor architecture.

### Brief Description of the Drawings

Fig. 1 is block diagram of a typical prior art processor architecture employing "segmented" arithmetic units.
Fig. 2 illustrates graphically the operation of a prior art four stage pipelined processor undergoing a multi-cycle branch operation.
Fig. 3 is a logical flow diagram illustrating the generalized methodology of controlling branching within a pipelined processor via a first interlock mode according to the present invention.
Fig. 4 is a schematic diagram illustrating a first embodiment of synthesized logic (unconstrained) used to implement the jump pipeline interlock methodology of Fig.3.
Fig. 5 is a schematic diagram illustrating a second embodiment of synthesized logic (constrained) used to implement the jump pipeline interlock methodology of Fig. 3.
Fig. 6 is a logical flow diagram illustrating the generalized methodology of controlling branching within a pipelined processor via a second interlock mode according to the present invention.
Fig. 7 is a schematic diagram illustrating a first embodiment of synthesized logic (unconstrained) used to implement the jump pipeline interlock methodology of Fig.6.
Fig. 8 is a schematic diagram illustrating a second embodiment of synthesized logic (constrained) used to implement the jump pipeline interlock methodology of Fig. 6.
Fig. 9 is a logical flow diagram illustrating the generalized methodology of synthesizing processor logic which incorporates jump control interlocks according to the present invention.
Fig. 10 is a block diagram of a processor design incorporating pipeline interlocking according to the present invention.
Fig. 11 is a functional block diagram of a computing device incorporating the hardware description language of the present invention, used to synthesize the logic apparatus of Figs. 4-5 and 7-8.

### Detailed Description of the Invention

Reference is now made to the drawings wherein like numerals refer to like parts throughout.

As used herein, the term "processor" is meant to include any integrated circuit or other electronic device capable of performing an operation on at least one instruction word including, without limitation, reduced instruction set core (RISC) processors such as the ARC user-configurable core manufactured by the Assignee hereof, central processing units (CPUs), and digital signal processors (DSPs). The hardware of such devices may be integrated onto a single piece of silicon ("die"), or distributed among two or more die. Furthermore, various functional aspects of the processor may be implemented solely as software or firmware associated with the processor.

Additionally, it will be recognized by those of ordinary skill in the art that the term "stage" as used herein refers to various successive stages within a pipelined processor; i.e., stage 1 refers to the first pipelined stage, stage 2 to the second pipelined stage, and so forth.

It is also noted that while the following description is cast in terms of VHSIC hardware description language (VHDL), other hardware description languages such as Verilog® may be used to describe various embodiments of the invention with equal success. Furthermore, while an exemplary Synopsys® synthesis engine such as the Design Compiler 1999.05 (DC99) is used to synthesize the various embodiments set forth herein, other synthesis engines such as Buildgates® available from, inter alia, Cadence Design Systems, Inc., may be used. IEEE std. 1076.3-1997, IEEE Standard VHDL Synthesis Packages, describe an industry-accepted language for specifying a Hardware Definition Language-based design and the synthesis capabilities that may be expected to be available to one of ordinary skill in the art.

Lastly, it will be recognized that while the following description illustrates specific embodiments of logic synthesized by the Assignee hereof using the aforementioned synthesis engine and VHSIC hardware description language, such specific embodiments being constrained in different ways, these embodiments are only exemplary and illustrative of the design process of the present invention. Furthermore, while a 1.0 um process was specified for these embodiments, other fabrication processes (such as 0.35 um or 0.18 um) may conceivably be used in conjunction with the invention disclosed herein.

The improved method of controlling jumping (including branching, loop setup, subroutine calls, etc.) within a processor according to the present invention is now described.

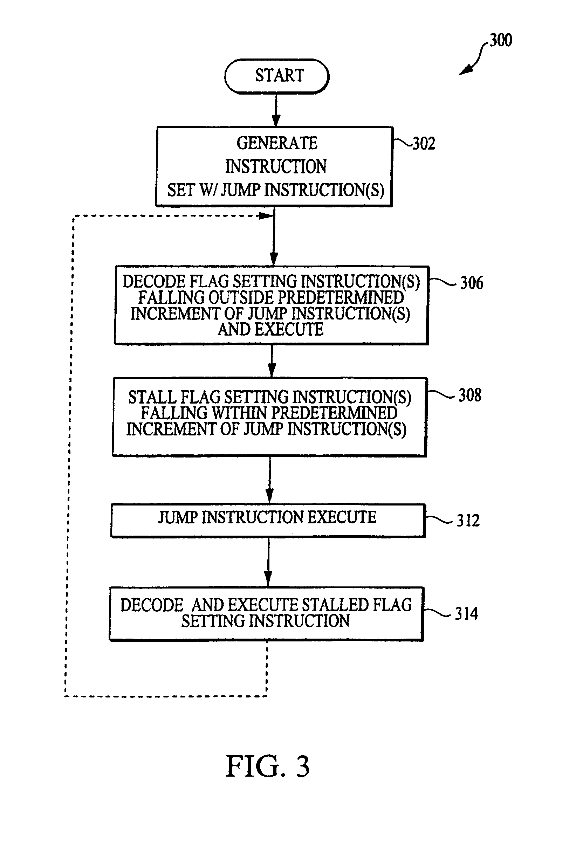

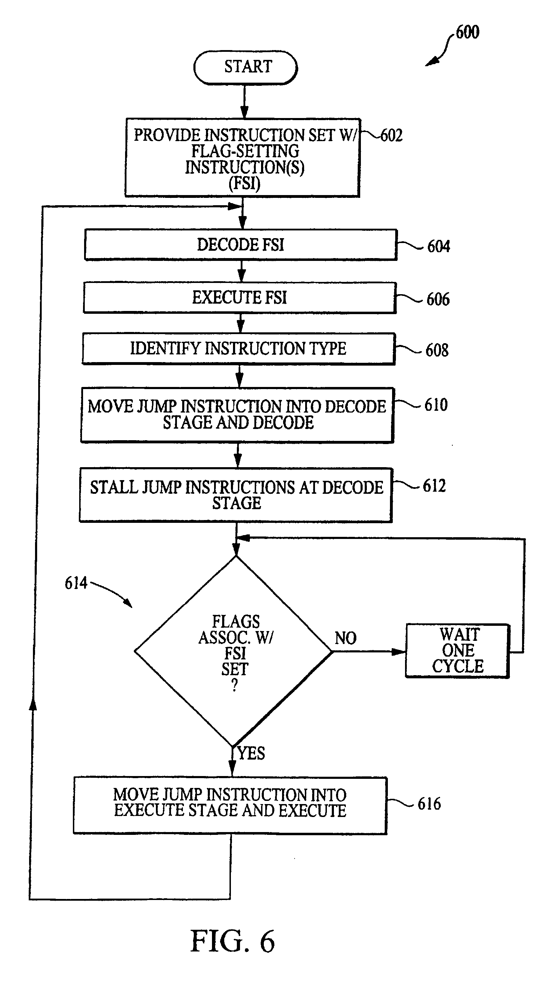

The method of the present invention generally comprises constructing one or more interlocks between an instruction word within the instruction set of the processor which sets a flag and a jump (instruction) taken as a result of that flag. In one embodiment described with respect to Fig. 3 below, flag setting instructions preceding a given jump instruction by a predetermined number of cycles are prohibited from affecting the execution of that jump. For example, a minimum number of cycles (n) are required between a flag setting instruction and any jump taken as a result of the flags set by that instruction. In another embodiment (Fig. 6), the jump instruction at a first stage is delayed until the flag setting instruction at a later stage is moved out of that stage. It is assumed for purposes of illustration that the processor architecture executes one instruction per machine cycle, although it will be appreciated that other architectures may be used.

Consider a pipelined architecture where a jump instruction can be conditional on a processor flag, and the jump instruction is executed in an earlier pipeline stage than an instruction that can set the flag. It would be possible to execute a flag setting instruction at the same time as a conditional jump, since the two instructions can be at different stages in the pipeline at the same time. Assuming that the processor flags are updated at the end of each cycle, the conditional jump would determine whether to change program flow based on the value of the flag at the beginning of the cycle, rather than the value of the flag which has been calculated during the cycle by the flag-setting instruction. Thus the jump instruction will not be affected by the result of the flag-setting instruction.

In order to ensure that the jump instruction will use the flag value set by the flag-setting instruction, the jump instruction cannot be executed until the flag value has been updated. A number (n) of cycles are therefore required between the execution of the flag-setting instruction and the execution of the jump instruction.

However, if the jump instruction was stalled in the pipeline for some reason, and the flag-setting instruction in a later pipeline stage unaffected by the stall was allowed to complete and update the processor flag, then when the jump was allowed to continue, it would be conditional on the updated processor flag and a different result could be obtained.

The skilful programmer will want to ensure that useful instructions can be executed in the required period between the flag-setting instruction and the jump instruction. Without the invention described here, the programmer would have to ensure that any instruction placed between the flag-setting instruction and the jump instruction would never alter the value of the processor flag being tested by the jump instruction.

The improved method and apparatus described herein allows the programmer to schedule a second flag-setting instruction in the required period between a first flag-setting instruction and its corresponding conditional jump, and be sure that the conditional jump would not be affected by the second flag-setting instruction if the jump were stalled in the pipeline. This would, for example, allow a second conditional jump instruction to be paired with the second flag-setting instruction, in such a way that the two pairs of instructions can be made to 'overlap', thus saving execution time.

Referring now to Fig. 3, a first embodiment of the generalized method of controlling jumping within a pipelined processor according to the present invention is described. In a first step 302 of the method 300, a program adapted to run on the processor and comprising a plurality of instruction words is provided. Each instruction word in the program is represented by and comprises a plurality of data bits, and at least one of the instruction words comprises a flag setting instruction (such as the "xor.f" instruction discussed in greater detail below), and at least one other word comprises a jump instruction. It is noted however that as used herein, the term "jump" may refer to any branch, jump, loop setup, or call instructions, although other instructions requiring a change in the flow of the instruction processing of the processor may conceivably be used in conjunction with the disclosed invention. The form and content of both flag setting and jump instructions are generally well known in the digital processor arts.

The flag setting instruction word(s) may be in any order or relationship to the jump instruction word(s); however, it is the case that at least one flag setting word will precede at least one jump instruction word within the program. The relative proximity of this preceding flag setting word to a following jump instruction word (as measured by the number of machine or processor cycles corresponding to instruction words in the program sequence) may also vary. Under the prior art approach, when the flag setting word precedes the jump instruction by less than a predetermined increment or number instruction words in the program sequence, the operation of the jump instruction may be affected by flags set by the flag-setting instruction immediately preceding it. Accordingly, the operation of the jump may vary dependent upon whether or not a flag setting instruction is scheduled into the slot(s) preceding the jump; this behavior needs to be explicitly considered by the device programmer.

In contrast, the interlock feature of the present embodiment precludes a flag setting instruction which occurs less than a predetermined increment before a jump instruction from affecting the operation of that jump. Specifically, in the illustrated embodiment, the increment comprises one machine cycle, and accordingly any flags set within the arithmetic logic unit (ALU) or other units within the processor within the cycle or slot immediately preceding the jump cannot set the flags before the jump instruction has completed, and thus it can not change the flags (such as those of the ALU) which the jump will consider

As a general proposition, the interlock signal of the illustrated embodiment is not set true (i.e., the interlock is not enabled) when a load is in stage 3 to prevent a possible lockup situation between a jump instruction (e.g., "Jcc rn") in stage 2, and a load instruction (e.g., "LD rn, [...]") in stage 3. In this case, the scoreboard could prevent the load from completing, which would mean that the scoreboard would never be cleared, resulting in a complete deadlock situation. Such exclusion of loads is not considered problematic with respect to the present invention since loads cannot set the flags.

In step 306, the flag setting instruction(s) occurring before one instruction prior to the jump instruction is decoded and executed, thereby setting the designated flags within the ALU or other registers within the processor. It is noted that in the present embodiment, a jump instruction in stage 2 and a flag-setting instruction in stage 3 must be decoded before the relationship between them can be analyzed.

Next, in step 308, the processor pipeline has moved on from step 306, and the logic has analyzed the relationship between any jump and flag setting instructions present in the pipeline. The interlock has determined that a flag setting instruction is present in pipeline stage 3, immediately preceding a jump instruction present at stage 2. The jump instruction is to be stalled at the end of present cycle, since a stall-request signal for stage 2 is set true. In order to prevent the flag setting instruction from affecting the subsequent jump, the flag setting instruction must also stalled at the end of the present cycle. The interlock generates a stall request signal for stage 3. At the end of the cycle, the stall-request signals prevent the instructions in stage 2 and 3 from moving to the next stage in the pipeline.

In step 312, the at least one jump instruction scheduled after the flag setting instruction is decoded and executed by the processor at some later time when the stage 2 stall is removed, and the designated jump taken. Methods and apparatus useful for instruction decoding are well known in the computer arts, and accordingly will not be described further herein.

In step 314, the stalled (second) flag setting instruction is decoded and executed at the same time as completion of the jump of step 312. The simultaneous completion ensures that the second flag setting instruction does not affect the outcome of the jump.

The following example of the method of Fig. 3, (specifically in the context of Version 5 or "v5" of Applicant's ARC Core) is provided for illustration. As previously described, a minimum of one cycle is required between an instruction that sets the flags and a branch taken as a result of those flags; this allows an instruction which sets flags to be scheduled in the pre-branch slot which cannot affect the branch outcome as follows:
- xor.f 0,r1,-1: ; set flags for jz instruction
- and.f r0,r1,r2: ; does not affect branch outcome
- jz [r10]: ; take jump
Often times this slot will be filled with a NOP (non-operation) instruction as illustrated in the following example:
- xor.f 0,r0,-2: ; test if r0 is -2
- nop: ; leave a blank slot ("padding")
- bz r0_is_minus_2: ; take branch
The v5 interlock is designed to ensure that when the second flag-setting instruction reaches stage 3, it cannot set the flags before the branch instruction has completed, and thus it can not change the flags (such as those of the ALU) which the branch will consider. In the foregoing example, the interlock detects the cases when this may occur, and stalls the flag setting instruction in stage 3.

The v5 interlock signal ("ibch_holdp3") of the illustrated embodiment further considers three types of stage 2 stall which can affect a jump;
i. The following instruction is not present
ii. A jump (e.g., Jcc [rn]) is referencing a scoreboarded register
iii. A jump (e.g., Jcc [rn]) is held up by an extension stage 2 stall

i. In the ARC v5 processor, the instruction immediately following a jump instruction is referred to as the 'delay slot' instruction. The jump instruction features modes to control the execution of the delay slot instruction depending on the outcome of the branch. In order for the execution of the following instruction to be controlled, it must be in the pipeline. Jump instructions can be stalled at stage 2 if the following instruction word is not available to be placed into stage 1, for example as a result of a cache 'miss'.
ii. If the target address for a jump is to be obtained from a register which is marked as the destination of an uncompleted load (a scoreboarded register), the jump must be stalled until the load has completed, and the register value updated.
iii. In the ARC v5 processor, an interface is provided for adding additional 'extension' registers. The interface allows an external stall signal to be generated. An external stall might stall a jump instruction at stage 2 if an extension register was referenced by the jump instruction and the extension register was not able to return data on that cycle.

A summary VHDL representation of the foregoing "ibch_holdp3" interlock functionality is as follows: 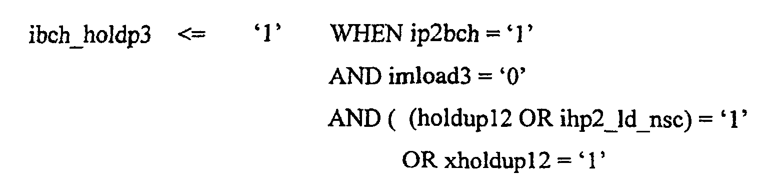 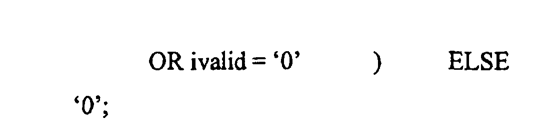 Note that the logic associated with the ibch_holdp3 will stall any instruction at stage 3 if a jump in stage 2 is stalled, unless the instruction at stage 3 is a load. In the present embodiment, the logic does not specifically check for a flag-setting instruction, just an instruction which may set the flags.

Appendix A hereto provides an exemplary VHDL representation used to synthesize the jump pipeline interlock of Version 5 (v5) of the ARC core.

It is noted that besides the aforementioned NOP scheduled into the pre-blanch slot, a skillful programmer may structure their code so as to perform some useful operation in this slot. The alternatives for such code are extensive, and depend upon the overall structure of the program as a whole. For example, in one instance it is possible to perform in the pre-branch slot the first logical operation of the code in the branch. This permits the pre-branch slot to be used for useful program execution. As another example, some algorithms may be partitioned so that the next instruction executed in both branches of the program flow is the same. In this case it is possible to code the instruction in the pre-branch slot so that it is executed regardless of whether or not the branch is taken. Many such alternatives are possible, and considered to fall within the scope of the invention disclosed herein.

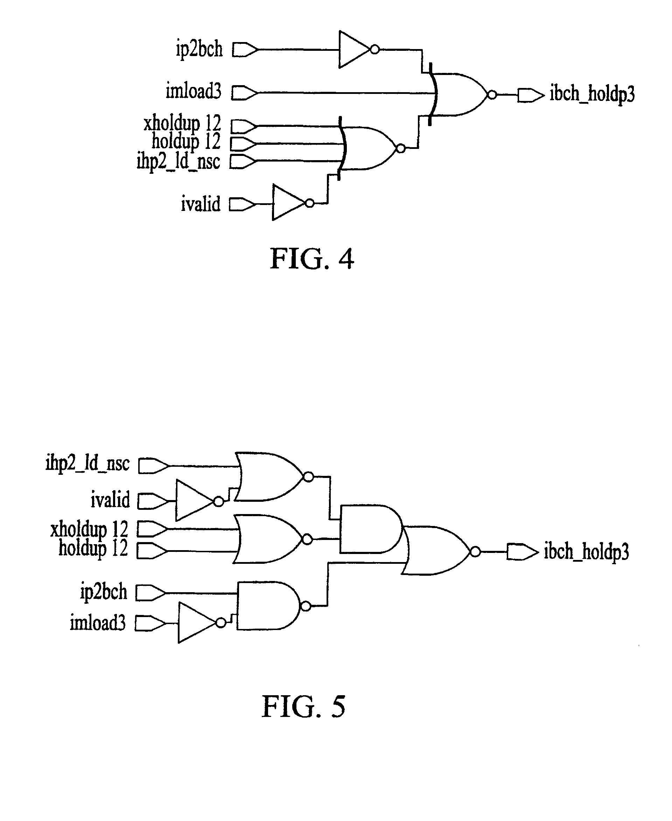

Fig. 4 illustrates a first embodiment of synthesized logic used to implement the v5 jump pipeline interlock of the present invention. The logic of Fig. 4 was synthesized using the aforementioned Synopsys® Design Compiler using an LSI 10k 1.0um process with no constraints.

Fig. 5 illustrating a second embodiment of the synthesized logic of the v5 jump pipeline interlock, except incorporating the constraint that the delay between ivalid and ibch_holdp3 is minimized. It will be recognized, however, that other constraints may be used in the alternative and/or in conjunction with the ivalid/ibch_holdp3 minimization constraint.

Referring now to Fig. 6, a second embodiment of the generalized method of controlling jumping within a pipelined processor according to the present invention is described. In a first step 602 of the method 600, an instruction set adapted to run on the processor and comprising a plurality of instruction words is provided as previously described. At least one of the instruction words comprises a flag setting instruction (such as the "xor.f" instruction in the example above), and at least one other word comprises a jump instruction.

In contrast to the method of Fig. 3 herein, however, the interlock of the embodiment of Fig. 6 does not permit scheduling a NOP or flag setting instruction into the slot immediately preceding the jump. Rather, the processor first moves the flag setting instruction into the decode stage and decodes the instruction in step 604. Next, in step 606, the flag setting instruction is moved into the execution stage and executed. At this point, the identity of the instruction in the execution stage is determined (step 608); exemplary code useful for making this determination is described below with respect to Table 1. The jump instruction is moved into the decode stage and decoded per step 610. The jump instruction is stalled in the decode stage (step 612) until the flag setting instruction has moved out of the execution stage and the flags set accordingly per step 614. Note that the stall of step 612 only occurs if it is determined in step 608 that a flag setting operation is present. The jump instruction is then moved into the execution stage and executed in step 616. As will be readily appreciated, this approach allows, inter alia, a more compact code to be written for an "if-then" structure. Furthermore, it will be appreciated that many of the foregoing steps (such as movement of the flag setting instruction into the execution stage and movement of the jump instruction into the decode stage) may occur simultaneously.

The following exemplary code structure (relating to Version 6 or "v6" of the ARC Core) illustrates the methodology of Fig. 6:
- v6 code:: xor.f 0,r0,-2 ; test if r0 is -2
bz r0_is_minus_2 ; take branch
The v6 interlock code structure above allows the NOP of the v5 code (Fig. 3 herein) to be omitted, since the branch at stage 2 will be delayed until the flag-setting instruction has moved out of stage 3 and the flags have been set. The v6 code takes the same time to execute as the v5 code, but a significant saving is made in code size, since many NOPs present in the v5 code are left out.

The following types of valid instructions must be detected and identified at stage 3 in order to enable the v6 interlock:
i. Any ALU instruction which sets the flags (e.g., "p3setflags")
ii. Flag setting jump instructions (e.g., Jcc.F or JLcc.F)*
iii. A FLAG instruction These flag-setting jump instructions are used to return from subroutines or interrupts since they allow the 32-bit register which contains the program counter and processor flags to be reloaded simultaneously from a single saved 32-bit quantity in a register.

Detection of these instructions is accomplished in the present embodiment as illustrated in Table 1:

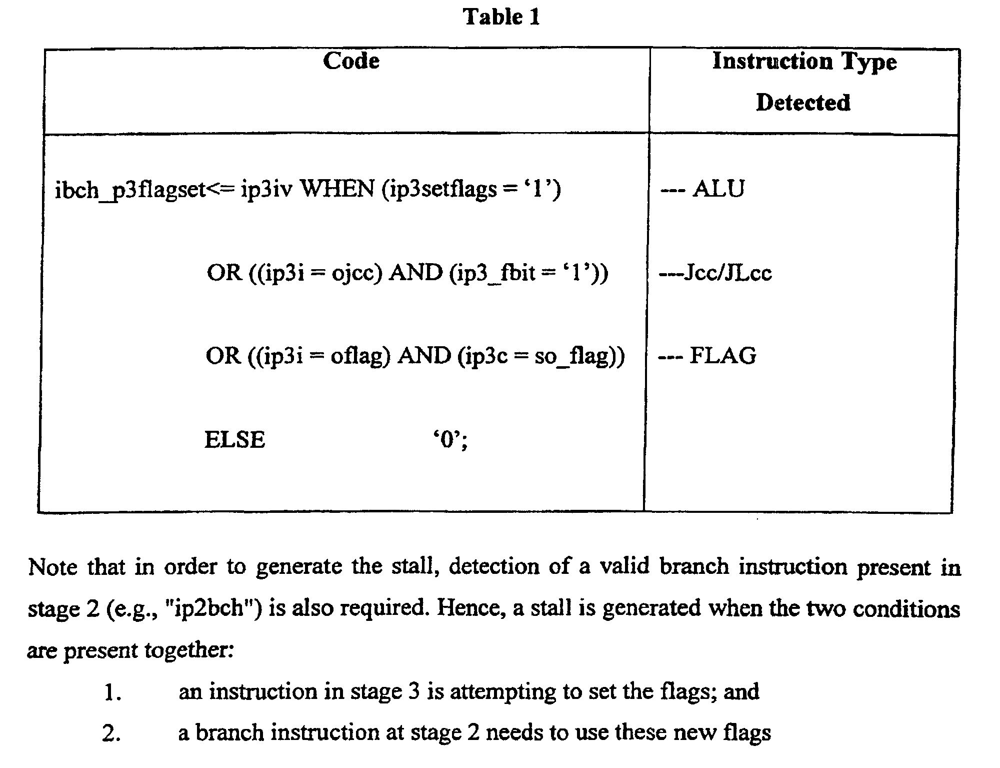

The following exemplary code structure is used in v6 to determine the truth of these two conditions:

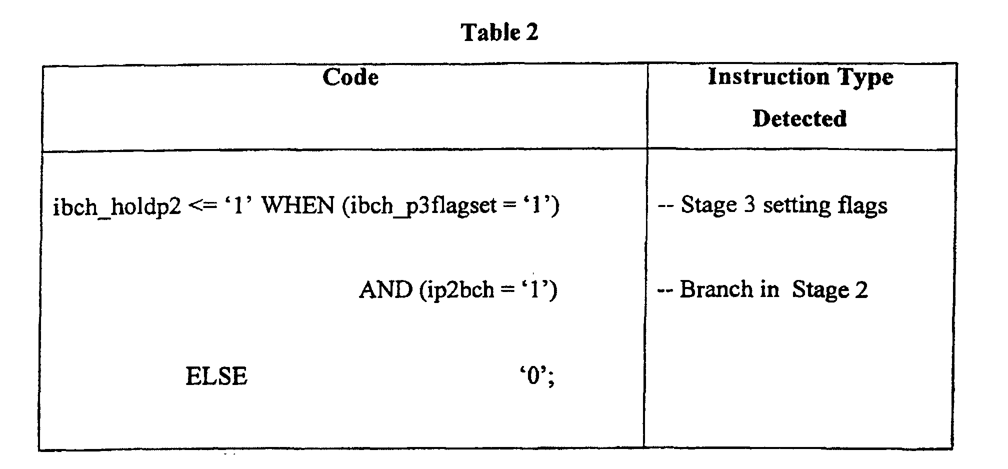

Note that in the illustrated embodiment, it is also possible to detect the those program conditions in which either (a) the flags do not get set; or (b) the following branch instruction does not check the flags that are set. In both conditions, the link between setting the flags and the following branch is removed. Accordingly, detection of these conditions provides further potential improvements in processor performance since it would not be necessary to generate a stall for the flag set/branch combination if it could be detected that the flags would not be set (if the instruction is subsequently killed), or that the flags which would be set by the instruction are not tested by the branch condition chosen.

The following specific examples of the v6 code are illustrative of the foregoing concept:
i. Conditional flag set instruction at stage 3 does not set flags
   (e.g., add.cc.f r0,r0,r0, resulting in c=1)
ii. Branch at stage 2 uses the AL (always) condition code.

Appendix B hereto includes an exemplary jump pipeline interlock VHDL representation according to the present invention, as used for synthesis with Version 6 (v6) of the ARC Core. It will be recognized, however, that the foregoing methodology is not limited to this one specific application, but rather may be utilized in conjunction with any number of different processor designs.

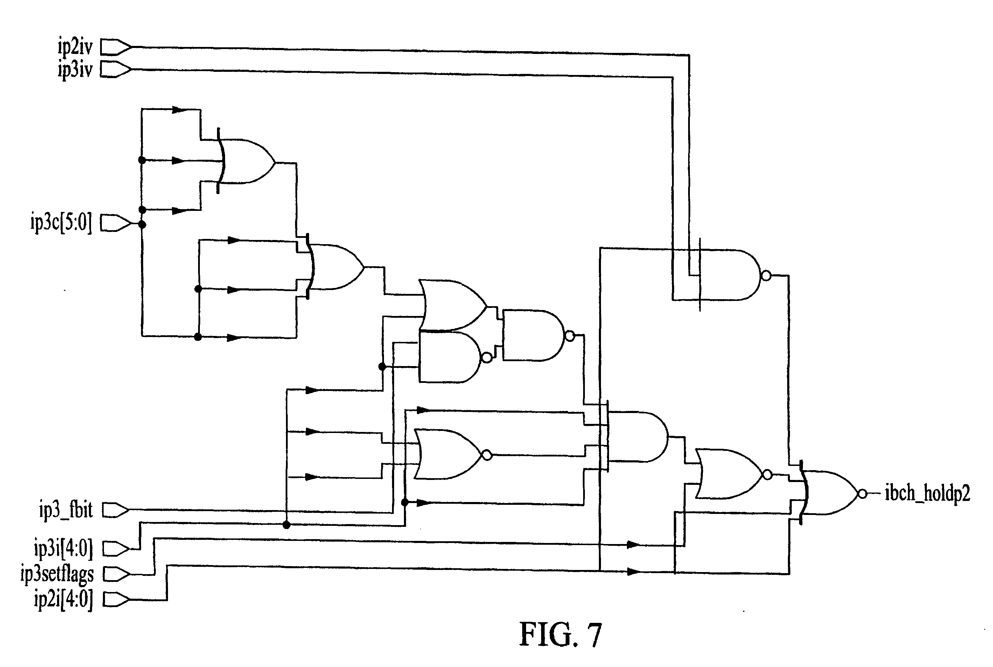

Fig. 7 illustrates a first embodiment of synthesized logic used to implement the v6 jump pipeline interlock of the present invention. The logic of Fig. 7 was synthesized using the aforementioned Synopsys® Design Compiler using an LSI 10k 1.0um process with no constraints.

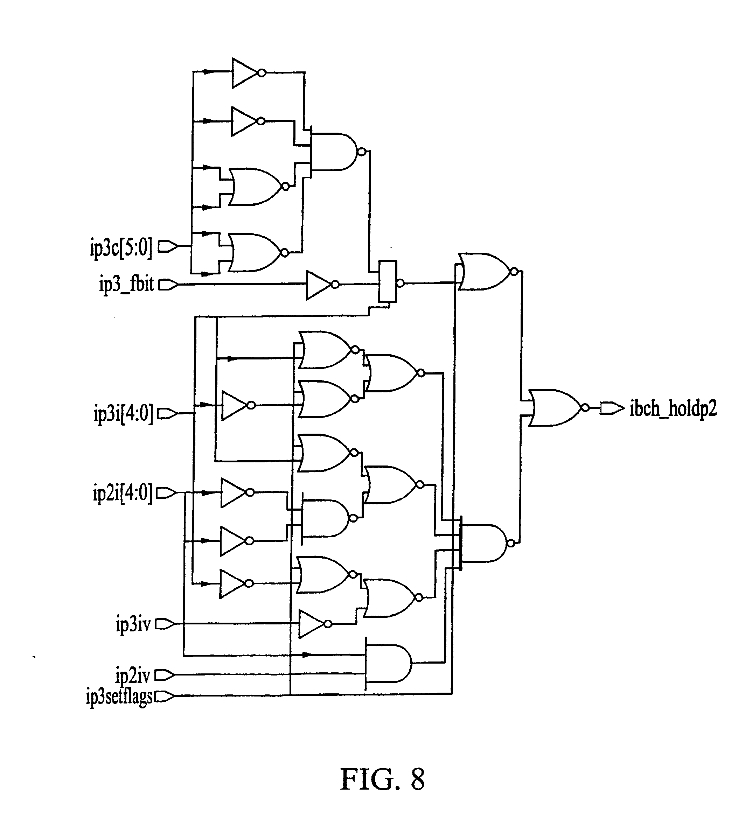

Fig. 8 illustrates a second embodiment of the synthesized logic of the v6 jump pipeline interlock, except incorporating the constraint that the delay between the inputs and ibch_holdp3 is minimized. The logic of Fig. 8 was also synthesized using the aforementioned Synopsys® Design Compiler using an LSI 10k 1.0um process.

It will further be recognized that the jump pipeline interlock functionality as embodied in v5 or v6 (or other embodiments consistent with the present invention) may be integrated with other jump control or pipeline interlocking techniques. See for example, the jump delay slot modes described in Applicant's co-pending U.S. Patent Application entitled "Method And Apparatus For Jump Delay Slot Control In A Pipelined Processor," and the pipeline tearing and catch-up methods of Applicant's co-pending U.S. Patent Application entitled "Method and Apparatus for Processor Pipeline Segmentation and ReAssembly," both filed contemporaneously herewith, and both which are incorporated by reference herein in their entirety. Furthermore, various register encoding schemes such as disclosed in Applicant's co-pending U.S. Patent Application entitled "Method and Apparatus for Loose Register Encoding Within a Pipelined Processor," filed contemporaneously herewith, and incorporated by reference in its entirety, may also be used in conjunction with the present invention.

### Method of Synthesizing

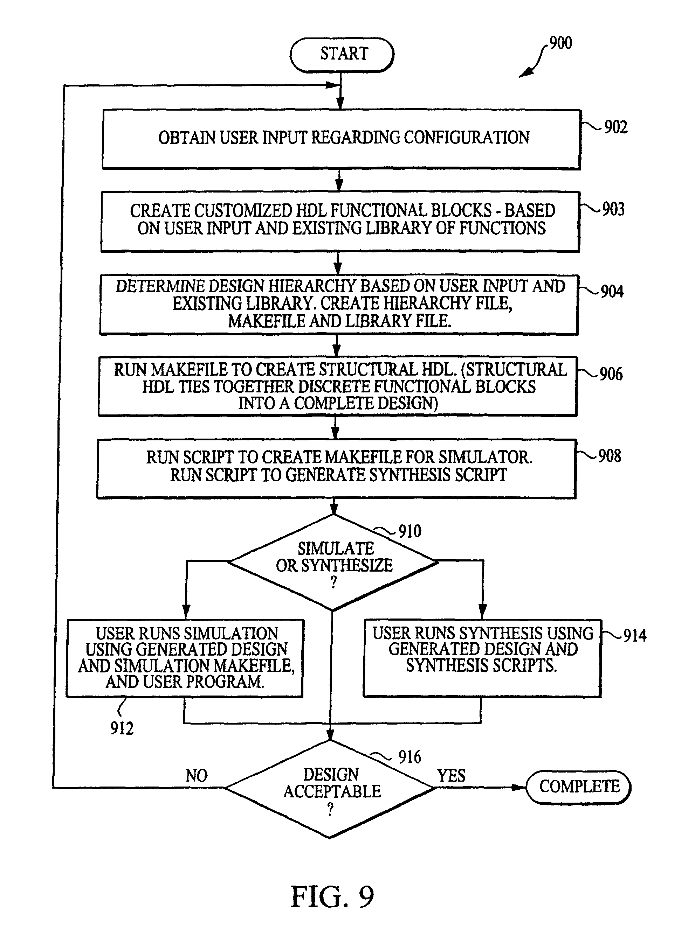

Referring now to Fig. 9, the method 900 of synthesizing logic incorporating the jump pipeline interlock functionality previously discussed is described. The generalized method of synthesizing integrated circuit logic having a user-customized (i.e., "soft") instruction set is disclosed in Applicant's co-pending U.S. Patent Application Serial No. 09/418,663 entitled "Method And Apparatus For Managing The Configuration And Functionality Of A Semiconductor Design" filed October 14, 1999, which is incorporated herein by reference in its entirety.

While the following description is presented in terms of an algorithm or computer program running on a microcomputer or other similar processing device, it can be appreciated that other hardware environments (including minicomputers, workstations, networked computers, "supercomputers", and mainframes) may be used to practice the method. Additionally, one or more portions of the computer program may be embodied in hardware or firmware as opposed to software if desired, such alternate embodiments being well within the skill of the computer artisan.

Initially, user input is obtained regarding the design configuration in the first step 902. Specifically, desired modules or functions for the design are selected by the user, and instructions relating to the design are added, subtracted, or generated as necessary. For example, in signal processing applications, it is often advantageous for CPUs to include a single "multiply and accumulate" (MAC) instruction. In the present invention, the instruction set of the synthesized design is modified so as to incorporate the foregoing jump pipeline interlocks (or another comparable interlock/control architecture) therein. The technology library location for each VHDL file is also defined by the user in step 902. The technology library files in the present invention store all of the information related to cells necessary for the synthesis process, including for example logical function, input/output timing, and any associated constraints. In the present invention, each user can define his/her own library name and location(s), thereby adding further flexibility.

Next, in step 903, customized HDL functional blocks based on the user's input and the existing library of functions specified in step 902 are created.

In step 904, the design hierarchy is determined based on the user's input and the aforementioned library files. A hierarchy file, new library file, and makefile are subsequently generated based on the design hierarchy. The term "makefile" as used herein refers to the commonly used UNIX makefile function or similar function of a computer system well known to those of skill in the computer programming arts. The makefile function causes other programs or algorithms resident in the computer system to be executed in the specified order. In addition, it further specifies the names or locations of data files and other information necessary to the successful operation of the specified programs. It is noted, however, that the invention disclosed herein may utilize file structures other than the "makefile" type to produce the desired functionality.

In one embodiment of the makefile generation process of the present invention, the user is interactively asked via display prompts to input information relating to the desired design such as the type of "build" (e.g., overall device or system configuration), width of the external memory system data bus, different types of extensions, cache type/size, etc. Many other configurations and sources of input information may be used, however, consistent with the invention.

In step 906, the makefile generated in step 904 is run to create the structural HDL. This structural HDL ties the discrete functional block in the design together so as to make a complete design.

Next, in step 908, the script generated in step 906 is run to create a makefile for the simulator. The script to generate a synthesis script is also run in step 908.

At this point in the program, a decision is made whether to synthesize or simulate the design (step 910). If simulation is chosen, the user runs the simulation using the generated design and simulation makefile (and user program) in step 912. Alternatively, if synthesis is chosen, the user runs the synthesis using the synthesis script(s) and generated design in step 914. After completion of the synthesis/simulation scripts, the adequacy of the design is evaluated in step 916. For example, a synthesis engine may create a specific physical layout of the design that meets the performance criteria of the overall design process yet does not meet the die size requirements. In this case, the designer will make changes to the control files, libraries, or other elements that can affect the die size. The resulting set of design information is then used to re-run the synthesis script.

If the generated design is acceptable, the design process is completed. If the design is not acceptable, the process steps beginning with step 902 are re-performed until an acceptable design is achieved. In this fashion, the method 900 is iterative.

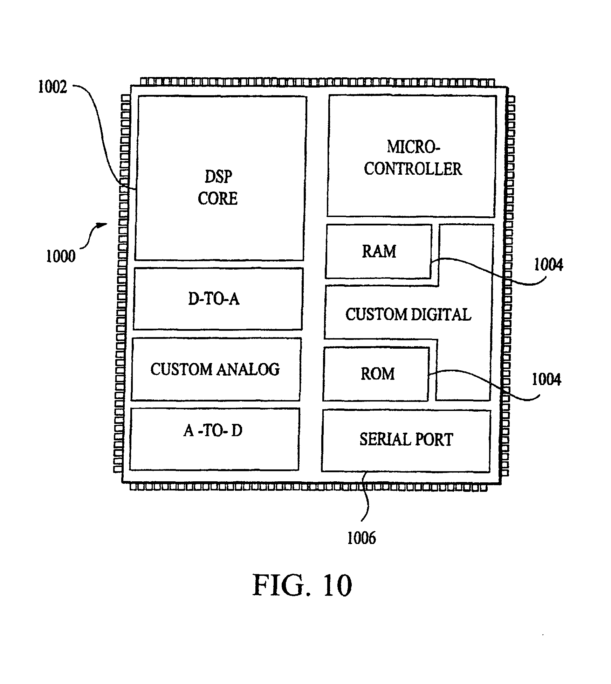

Fig. 10 illustrates an exemplary pipelined processor fabricated using a 1.0 um process and incorporating the logic of Figs. 4, 5, 7 or 8 and the jump pipeline interlock functionality previously described herein. As shown in Fig. 10, the processor 1000 is an ARC microprocessor-like CPU device having, inter alia, a processor core 1002, on-chip memory 1004, and an external interface 1006. The device is fabricated using the customized VHDL design obtained using the method 900 of the present invention, which is subsequently synthesized into a logic level representation, and then reduced to a physical device using compilation, layout and fabrication techniques well known in the semiconductor arts.

It will be appreciated by one skilled in the art that the processor of Figure 7 may contain any commonly available peripheral such as serial communications devices, parallel ports, timers, counters, high current drivers, analog to digital (A/D) converters, digital to analog converters (D/A), interrupt processors, LCD drivers, memories and other similar devices. Further, the processor may also include custom or application specific circuitry. The present invention is not limited to the type, number or complexity of peripherals and other circuitry that may be combined using the method and apparatus. Rather, any limitations are imposed by the physical capacity of the extant semiconductor processes which improve over time. Therefore it is anticipated that the complexity and degree of integration possible employing the present invention will further increase as semiconductor processes improve.

It is also noted that many IC designs currently use a microprocessor core and a DSP core. The DSP however, might only be required for a limited number of DSP functions, or for the IC's fast DMA architecture. The invention disclosed herein can support many DSP instruction functions, and its fast local RAM system gives immediate access to data. Appreciable cost savings may be realized by using the methods disclosed herein for both the CPU & DSP functions of the IC.

Additionally, it will be noted that the methodology (and associated computer program) as previously described herein can readily be adapted to newer manufacturing technologies, such as 0.35, 0.18 or 0.1 micron processes, with a comparatively simple resynthesis instead of the lengthy and expensive process typically required to adapt such technologies using "hard" macro prior art systems.

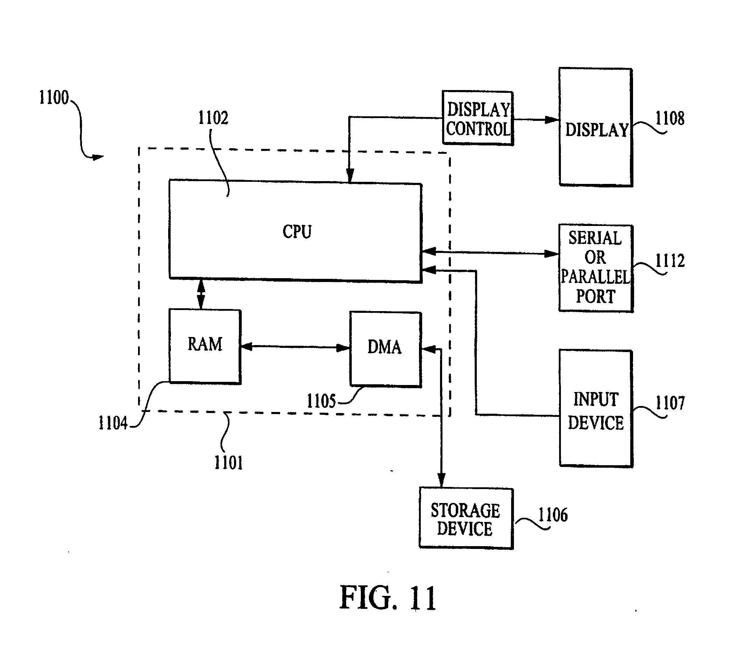

Referring now to Fig. 11, one embodiment of a computing device capable of synthesizing, inter alia, the jump pipeline interlock logic structures of Figs. 4-5 and 7-8 herein is described. The computing device 1100 comprises a motherboard 1101 having a central processing unit (CPU) 1102, random access memory (RAM) 1104, and memory controller 1105. A storage device 1106 (such as a hard disk drive or CD-ROM), input device 1107 (such as a keyboard or mouse), and display device 1108 (such as a CRT, plasma, or TFT display), as well as buses necessary to support the operation of the host and peripheral components, are also provided. The aforementioned VHDL descriptions and synthesis engine are stored in the form of an object code representation of a computer program in the RAM 1104 and/or storage device 1106 for use by the CPU 1102 during design synthesis, the latter being well known in the computing arts. The user (not shown) synthesizes logic designs by inputting design configuration specifications into the synthesis program via the program displays and the input device 1107 during system operation. Synthesized designs generated by the program are stored in the storage device 1106 for later retrieval, displayed on the graphic display device 1108, or output to an external device such as a printer, data storage unit, other peripheral component via a serial or parallel port 1112 if desired.

While the above detailed description has shown, described, and pointed out novel features of the invention as applied to various embodiments, it will be understood that various omissions, substitutions, and changes in the form and details of the device or process illustrated may be made by those skilled in the art without departing from the invention. The foregoing description is of the best mode presently contemplated of carrying out the invention. This description is in no way meant to be limiting, but rather should be taken as illustrative of the general principles of the invention. The scope of the invention should be determined with reference to the claims.

### APPENDIX A - EXEMPLARY JUMP PIPELINE VHDL USED FOR SYNTHESIS (v5)

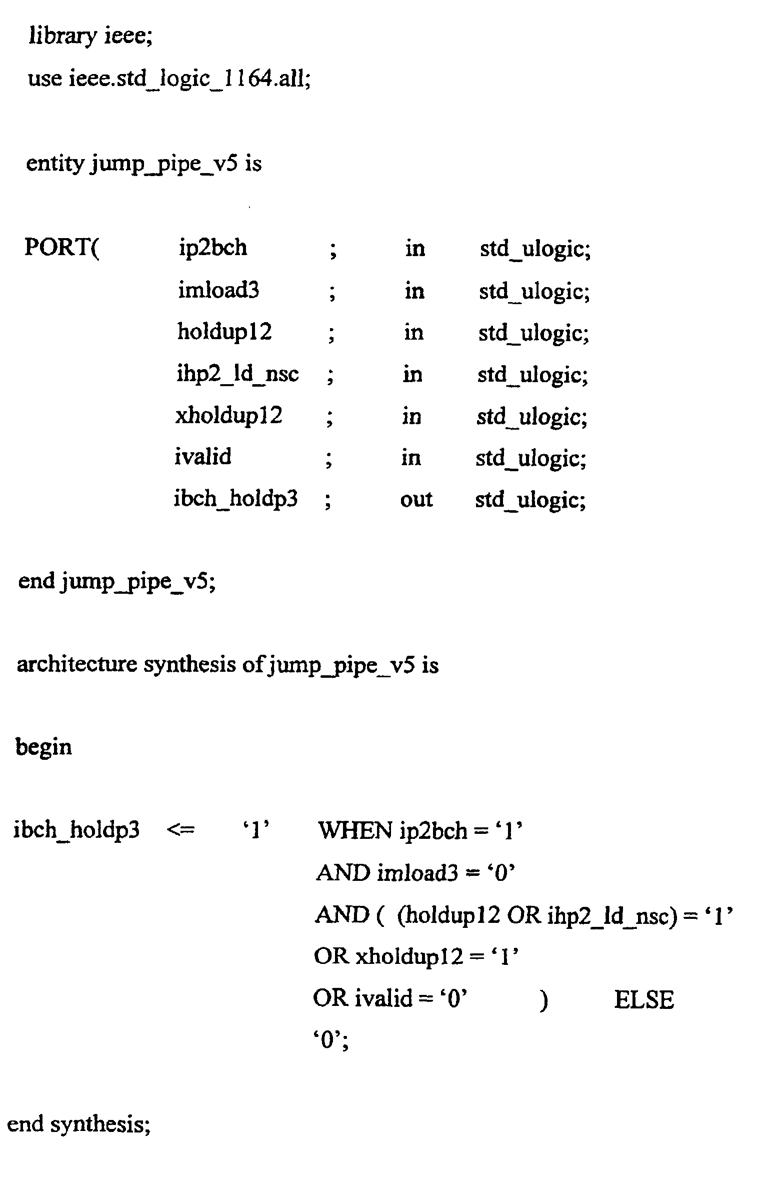

### APPENDIX B - EXEMPLARY JUMP PIPELINE VHDL USED FOR SYNTHESIS (v6)

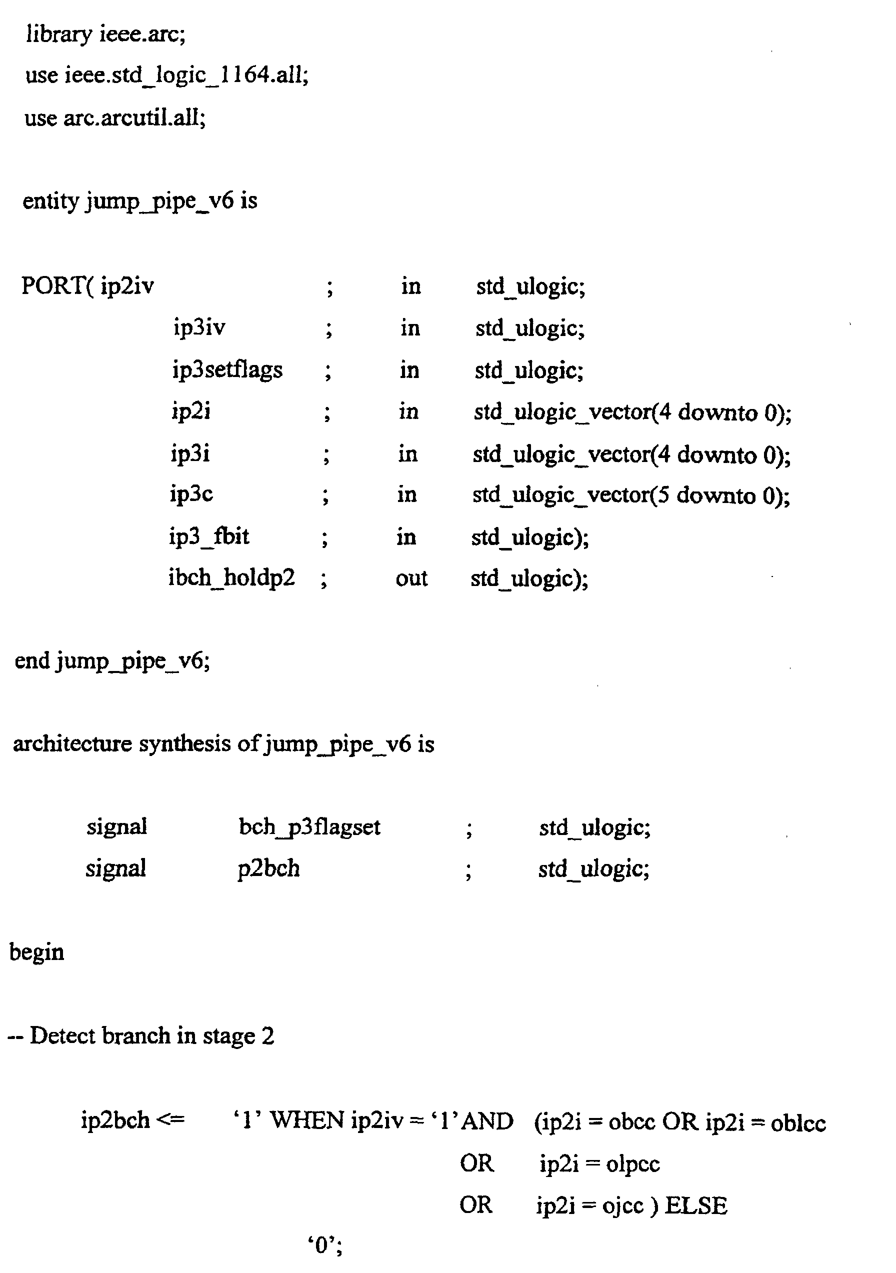

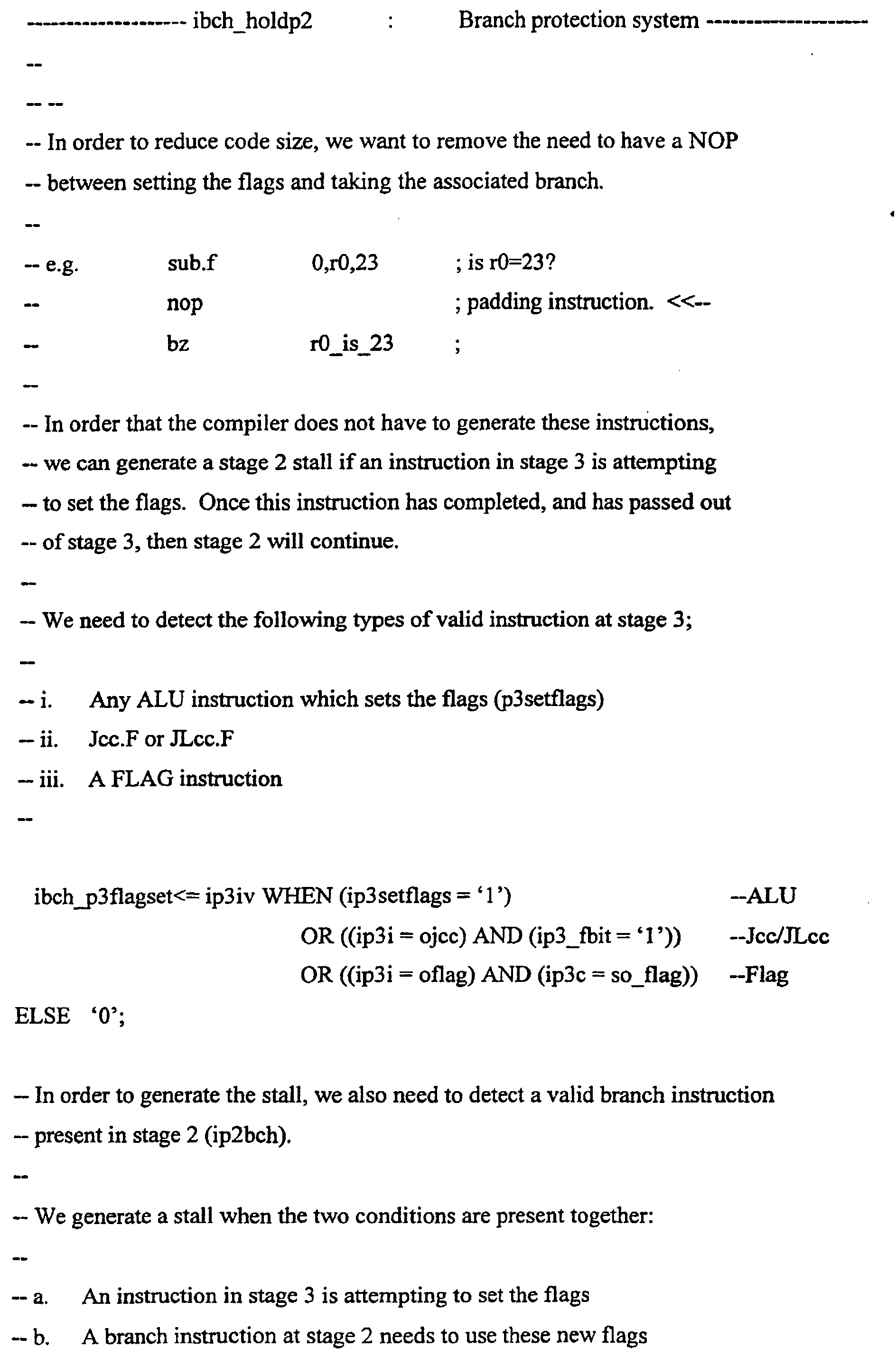

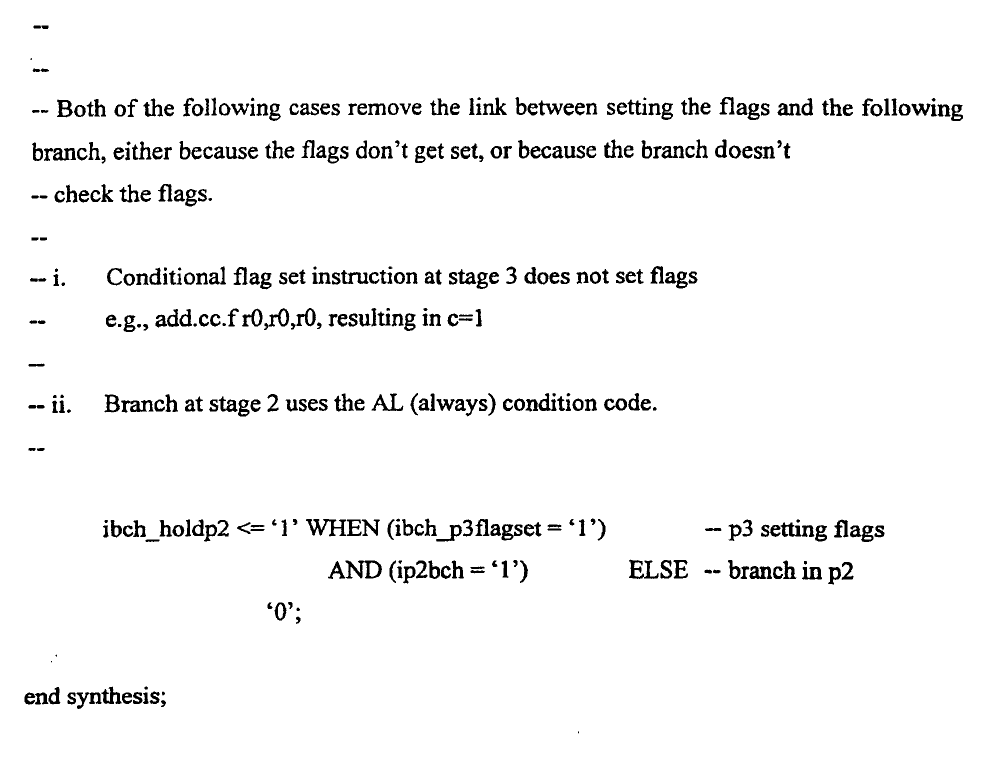

## Claims

1. A method (300) of controlling program branching within a pipelined processor (1000), comprising:
providing an instruction set comprising a plurality of instruction words, said plurality of instruction words comprising at least first and second flag setting instruction words and at least one branching instruction word, said first and second flag setting instruction words preceding said at least one branching instruction word within said instruction set, said second flag setting instruction falling within a predetermined increment of said at least one branching instruction;
decoding and executing said first flag setting instruction; and
stalling said second flag setting instruction within said pipeline at least until such time as the execution of said second flag setting instruction will not affect the operation of the branch.

2. The method of Claim 1, wherein said increment comprises one processor cycle.

3. The method of Claim 1, further comprising determining the value of said increment based on the value of at least one parameter, said at least one parameter relating at least in part to the type of instruction word present in at least one stage of the pipeline.

4. The method of Claim 1, further comprising:
decoding said second flag setting instruction;
stalling said second flag setting instruction prior to execution thereof; decoding said jump instruction; and
executing said jump instruction based at least in part on the flags set by said first flag setting instruction.

5. The method of Claim 1, wherein said processor pipeline comprises an at least three stage pipeline comprising fetch, decode, and execution stages.

6. The method of Claim 1, wherein the act of setting at least one flag comprises setting a plurality of flags with the arithmetic logic unit (ALU) of said processor.

7. A digital processor (1000) comprising:
a processor core (1002) having a multistage instruction pipeline, said core including decode and execute stages adapted to decode and execute an instruction set comprising a plurality of instruction words; and
an instruction set comprising at least first and second flag setting instructions, and at least one jump instruction which follows said first and second flag setting instructions within said pipeline, said second flag setting instruction failing within a predetermined increment of said jump instruction;
wherein said processor (1000) and said instruction set are adapted to:
(i) decode and execute said first flag setting instruction; and
(ii) stall said second flag setting instruction within said pipeline at least until such time as the execution of said second flag setting instruction will not affect the operation of the jump instruction.

8. The processor of Claim 7, wherein said processor (1000) is further adapted to stall said at least one jump instruction within the decode stage of said pipeline if the instruction scheduled into the slot immediately following said at least one jump instruction is not available for insertion into the first stage of said pipeline.

9. The processor of claims 7 or 8, wherein said processor (1000) is further adapted to stall said at least one jump instruction when the target address for such jump is to be obtained from a register comprising the destination of an uncompleted load operation.

10. The processor of any of the claims 7-9, wherein said processor (1000) is further adapted to stall said at least one jump instruction upon the failure of an extension register to return a referenced data value within a given machine cycle.

11. The processor of any of the claims 7-10, wherein said second flag setting instruction comprises the first instruction associated with the code sequence beginning at the target address of the jump.

12. The processor of any of the claims 7-11, wherein said flag setting instructions are selected from the group comprising:
(i) any ALU instruction which sets the flags;
(ii) flag setting jump instructions; and
(iii) a FLAG instruction.

13. The method of Claim 1, wherein said second flag setting instruction is executed substantially simultaneously with said branching instruction.

14. The method of Claim 1, further comprising providing at least one other branching instruction disposed subsequent to said second flag setting instruction within said pipeline such that a first pair of instructions, said first pair comprising said first flag setting instruction and said at least one branching instruction, at least partly overlaps a second pair of instructions, said second pair comprising said second flag instruction and said at least one other branching instruction, within said pipeline.

15. The method of Claim 1, further comprising stalling said at least one branching instruction within the decode stage of said pipeline if the instruction scheduled into the slot immediately following said at least one branching instruction is not available for insertion into the first stage of said pipeline.

16. The method of Claim 1, further comprising stalling said at least one branching instruction when the target address for said branching operation is to be obtained from a register comprising the destination of an uncompleted register load operation.

17. The method of Claim 1, further comprising stalling said at least one jump instruction upon the failure of an extension register to return a referenced data value within a given machine cycle.

## Patentansprüche

1. Verfahren (300) zum Steuern der Programmverzweigung in einem Prozessor (1000) mit Pipeline-Architektur, welches die folgenden Schritte umfasst:
- Bereitstellen eines Befehlsvorrats, der eine Vielzahl von Befehlswörtern umfaßt, wobei die Vielzahl von Befehlswörtern mindestens erste und zweite Befehlsworte zum Setzen eines Flags und mindestens ein Befehlswort zum Verzweigen umfasst, wobei die ersten und zweiten Befehlsworte zum Setzen eines Flags innerhalb des Befehlsvorrats dem mindestens einen Befehlswort zum Verzweigen vorangehen und wobei der zweite Befehl zum Setzen eines Flags in den Rahmen eines vorgegebenen Inkrements des mindestens einen Befehls zum Verzweigen fällt;
- Dekodieren und Ausführen des ersten Befehls zum Setzen eines Flags, und
- Anhalten des zweiten Befehls zum Setzen eines Flags innerhalb der Pipeline-Architektur zumindest bis zu dem Zeitpunkt, zu dem die Ausführung des zweiten Befehls zum Setzen eines Flags sich nicht auf den Betrieb des Zweigs auswirkt.

2. Verfahren nach Anspruch 1,
**dadurch gekennzeichnet, dass**
das Inkrement einen Prozessorzyklus umfasst.

3. Verfahren nach Anspruch 1,
**dadurch gekennzeichnet, dass**
des Weiteren die Bestimmung des Werts des Inkrements anhand des Werts von mindestens einem Parameter vorgesehen ist, wobei mindestens ein Parameter sich zumindest teilweise auf die Art des Befehlsworts bezieht, das in mindestens einer Stufe der Pipeline-Architektur vorhanden ist.

4. Verfahren nach Anspruch 1,
**dadurch gekennzeichnet, daß**
welches des Weiteren folgende Schritte umfasst sind:
- Dekodieren des zweiten Befehls zum Setzen eines Flags.
- Anhalten des zweiten Befehls zum Setzen eines Flags vor dessen Ausführung;
- Dekodieren des Sprungbefehls; und
- Ausführen des Sprungbefehls der zumindest teilweise auf dem Flag basiert, der mittels des ersten Befehls zum Setzen des Flags gesetzt worden ist.

5. Verfahren nach Anspruch 1,
**dadurch gekennzeichnet, dass**
die Pipeline-Architektur des Prozessors eine zumindest dreistufige Pipeline mit einer Abrufstufe, einer Dekodierstufe und einer Ausführstufe umfasst.

6. Verfahren nach Anspruch 1,
**dadurch gekennzeichnet, dass**
der Vorgang des Setzens von mindestens einem Flag das Setzen von einer Vielzahl von Flags mit der arithmetisch-logischen Einheit (ALU) des Prozessors umfasst.

7. Digitaler Prozessor (1000), welcher folgendes aufweist:
- einen Prozessorkern (1002) mit einer mehrstufigen Befehls-Pipeline, wobei der Kern Dekodier- und Ausführungsstufen umfasst, die zum Dekodieren und Ausführen eines Befehlsvorrats ausgelegt sind, der eine Vielzahl von Befehlswörtern umschließt; und
- einen Befehlsvorrat, der mindestens erste und zweite Befehle zum Setzen von Flags und mindestens einen Sprungbefehl umfasst, der innerhalb der Pipeline den ersten und zweiten Befehlen zum Setzen von Flags folgt, wobei der zweite Befehl zum Setzen von Flags in den Rahmen eines vorgegebenen Inkrements des Sprungbefehls fällt;
wobei der Prozessor (1000) und der Befehlsvorrat für folgendes ausgelegt sind:
(i) den ersten Befehl zum Setzen von Flags zu dekodieren und auszuführen; und
(ii) den zweiten Befehl zum Setzen von Flags innerhalb der Pipeline zumindest bis zu dem Zeitpunkt anzuhalten, zu dem die Ausführung des zweiten Befehls zum Setzen von Flags sich nicht auf die Operation des Sprungbefehls auswirkt.

8. Prozessor nach Anspruch 7,
**dadurch gekennzeichnet, dass**
bei welchem der Prozessor (1000) des Weiteren zum Anhalten des mindestens einen Sprungbefehls innerhalb der Dekodierstufe der Pipeline ausgelegt ist, wenn der Befehl, der in das Zeitfenster eingeplant ist, das unmittelbar auf den mindestens einen Sprungbefehl folgt, nicht zum Einfügen in die erste Stufe der Pipeline zur Verfügung steht.

9. Prozessor nach den Ansprüchen 7 oder 8,
**dadurch gekennzeichnet, dass**
der Prozessor (1000) des Weiteren so ausgelegt ist, dass er den mindestens einen Sprungbefehl anhält, wenn die Zieladresse für einen solchen Sprung aus einem Register erhalten werden soll, das die Bestimmung für einen eines unvollständigen Ladevorgang enthält.

10. Prozessor nach einem der Ansprüche 7 bis 9,
**dadurch gekennzeichnet, dass**
bei welchem der Prozessor (1000) des Weiteren so ausgelegt ist, dass er den mindestens einen Sprung befehl nach dem Ausfall eines Erweiterungsregisters zur Rückführung eines Bezugsdatenwerts innerhalb eines gegebenen Maschinenzyklus anhält.

11. Prozessor nach einem der Ansprüche 7 bis 10,
**dadurch gekennzeichnet, dass**
der zweite Befehl zum Setzen von Flags den ersten Befehl umfasst, welcher der Codefolge zugeordnet ist, die an der Zieladresse der Verzweigung beginnt.

12. Prozessor nach einem der Ansprüche 7 bis 11,
**dadurch gekennzeichnet, dass**
bei welchem die Befehle zum Setzen von Flags aus der Gruppe gewählt sind, die folgende umfasst:
(i) jeden Befehl der arithmetisch-logischen Einheit, welcher die Flags setzt;
(ii) Sprungbefehle zum Setzen von Flags; und
(iii) einen FLAG-Befehl.

13. Verfahren nach Anspruch 1,
**dadurch gekennzeichnet, dass**,
der zweite Befehl zum Setzen von Flags im Wesentlichen gleichzeitig mit dem Verzweigungsbefehl ausgeführt wird.

14. Verfahren nach Anspruch 1,
**dadurch gekennzeichnet, dass**
des Weiteren die Bereitstellung von mindestens einem weiteren Verzweigungsbefehl vorgesehen ist, der innerhalb der Pipeline hinter dem zweiten Befehl zum Setzen von Flags in der Weise angeordnet ist, dass sich ein erstes Paar von Befehlen, das den ersten Befehl zum Setzen von Flags und den mindestens einen Verzweigungsbefehl umfasst, zumindest teilweise mit einem zweiten Paar von Befehlen überschneidet, wobei das zweite Paar den zweiten Befehl zum Setzen von Flags und den mindestens einen weiteren Verzweigungsbefehl innerhalb der Pipeline umfasst.

15. Verfahren nach Anspruch 1,
**dadurch gekennzeichnet, dass**
des Weiteren das Anhalten des mindestens einen Verzweigungsbefehls innerhalb der Dekodierstufe der Pipeline vorgesehen ist, sofern der Befehl, der in das Zeitfenster eingeplant ist, das unmittelbar auf den mindestens einen Verzweigungsbefehl folgt, nicht zum Einfügen in die erste Stufe der Pipeline zur Verfügung steht.

16. Verfahren nach Anspruch 1,
**dadurch gekennzeichnet, dass**,
des Weiteren das Anhalten des mindestens einen Verzweigungsbefehls vorgesehen ist, wenn die Zieladresse für die Verzweigungsoperation aus einem Register abgerufen werden soll, das die Bestimmung für einen unvollständigen Ladevorgang des Registers enthält

17. Verfahren nach Anspruch 1,
**dadurch gekennzeichnet, dass**
des Weiteren das Anhalten des mindestens einen Sprungbefehls nach dem Ausfall eines Erweiterungsregisters zur Rückführung eines Bezugsdatenwerts innerhalb eines gegebenen Maschinenzyklus vorgesehen ist.

## Revendications

1. Procédé (300) de contrôle de branchement de programme dans un processeur en pipeline (1000), comprenant :
la fourniture d'un jeu d'instructions comprenant une pluralité de mots d'instruction, ladite pluralité de mots d'instruction comprenant au moins des premier et deuxième mots d'instruction positionnant des indicateurs, et
au moins un mot d'instruction de branchement, lesdits premier et deuxième mots d'instruction positionnant des indicateurs précédant ledit au moins un mot d'instruction de branchement dans ledit jeu d'instructions, ladite deuxième instruction positionnant des indicateurs tombant dans un incrément prédéterminé de ladite au moins une instruction de branchement ;
le décodage et l'exécution de ladite première instruction positionnant des indicateurs ; et
l'immobilisation de ladite deuxième instruction positionnant des indicateurs dans ledit pipeline au moins jusqu'à ce que l'exécution de ladite deuxième instruction positionnant des indicateurs n'affecte pas l'opération de branchement.

2. Procédé selon la revendication 1, dans lequel ledit incrément comprend un cycle de processeur.

3. Procédé selon la revendication 1, comprenant en outre la détermination de la valeur dudit incrément sur la base de la valeur d'au moins un paramètre, ledit au moins un paramètre concernant au moins en partie le type de mot d'instruction présent dans au moins un étage du pipeline.

4. Procédé selon la revendication 1, comprenant en outre :
le décodage de ladite deuxième instruction positionnant des indicateurs ;
l'immobilisation de ladite deuxième instruction positionnant des indicateurs avant son exécution ;
le décodage de ladite instruction de saut ; et
l'exécution de ladite instruction de saut sur la base au moins en partie des indicateurs positionnés par ladite première instruction positionnant des indicateurs.

5. Procédé selon la revendication 1, dans lequel ledit pipeline de processeur comprend un plpeline d'au moins trois étages comprenant des étages d'extraction, de décodage et d'exécution.

6. Procédé selon la revendication 1, dans lequel l'action de positionnement d'au moins un indicateur comprend le positionnement d'une pluralité d'indicateurs au moyen de l'unité arithmétique et logique (ALU) dudit processeur.

7. Processeur numérique (1000) comprenant :
un noyau de processeur (1002) comportant un pipeline d'instructions à étages multiples, ledit noyau comprenant des étages de décodage et d'exécution adaptés pour décoder et exécuter un jeu d'instructions comprenant une pluralité de mots d'instruction ; et
un jeu d'instructions comprenant au moins des première et deuxième instructions positionnant des indicateurs et au moins une instruction de saut qui suit lesdites première et deuxième instructions positionnant des indicateurs dans ledit pipeline, ladite deuxième instruction positionnant des indicateurs tombant dans un incrément prédéterminé de ladite instruction de saut ;
dans lequel ledit processeur (1000) et ledit jeu d'instructions sont adaptés pour :
(i) décoder et exécuter ladite première instruction positionnant des indicateurs ; et
(ii) immobiliser ladite deuxième instruction positionnant des indicateurs dans ledit pipeline au moins jusqu'à ce que l'exécution de ladite deuxième instruction positionnant des indicateurs n'affecte pas le déroulement de l'instruction de saut.

8. Processeur salon la revendication 7, dans lequel ledit processeur (1000) est, en outre, adapté pour immobiliser ladite au moins une instruction de saut dans l'étage de décodage dudit pipeline si l'instruction programmée dans la tranche de temps qui suit immédiatement ladite au moins une instruction de saut n'est pas disponible pour insertion dans le premier étage dudit pipeline.

9. Processeur selon la revendication 7 ou 8, dans lequel ledit processeur (1000) est, en outre, adapté pour immobiliser ladite au moins une instruction de saut lorsque l'adresse cible pour ce saut doit être obtenue d'un registre comprenant la destination d'une opération de chargement inachevée.

10. Processeur selon l'une quelconque des revendications 7 à 9, dans lequel ledit processeur (1000) est, en outre, adapté pour immobiliser ladite au moins une instruction de saut lorsqu'un registre d'extension ne renvoie pas une valeur de donnée référencée dans un cycle machine donné.

11. Processeur selon l'une quelconque des revendications 7 à 10, dans lequel ladite deuxième instruction positionnant des indicateurs comprend la première instruction associée à la séquence de codes commençant à l'adresse cible du saut.

12. Processeur selon l'une quelconque des revendications 7 à 11, dans lequel lesdites instructions positionnant des indicateurs sont sélectionnées dans le groupe comprenant :
(i) toute instruction d'unité arithmétique et logique qui positionne les indicateurs ;
(ii) des instructions de saut positionnant des indicateurs ; et
(iii) une instruction FLAG.

13. Procédé selon la revendication 1, dans lequel ladite deuxième instruction positionnant des indicateurs est exécutée sensiblement en même temps que ladite instruction de branchement.

14. Procédé selon la revendication 1, comprenant en outre la fourniture d'au moins une autre instruction de branchement disposée à la suite de ladite deuxième instruction positionnant des indicateurs dans ledit pipeline de telle sorte qu'une première paire d'instructions, ladite première paire comprenant ladite première instruction positionnant des indicateurs et ladite au moins une instruction de branchement, recouvre au moins partiellement une deuxième paire d'instructions, ladite deuxième paire comprenant ladite deuxième instruction positionnant des indicateurs et ladite au moins une autre instruction de branchement, dans ledit pipeline.

15. Procédé selon la revendication 1, comprenant en outre l'immobilisation de ladite au moins une instruction de branchement dans l'étage de décodage dudit pipeline si l'instruction programmée dans la tranche de temps qui suit immédiatement ladite au moins une instruction de branchement n'est pas disponible pour insertion dans le premier étage dudit pipeline.

16. Procédé selon la revendication 1, comprenant en outre l'immobilisation de ladite au moins une instruction de branchement lorsque l'adresse cible pour ladite opération de branchement doit être obtenue d'un registre comprenant la destination d'une opération de chargement de registre inachevée.

17. Procédé selon la revendication 1, comprenant en outre l'immobilisation de ladite au moins une instruction de saut lorsqu'un registre d'extension ne renvoie pas une valeur de donnée référencée dans un cycle machine donné.
